# EUROPEAN PATENT APPLICATION

(11) **EP 1 968 098 A1**
(43) Date of publication of application: **10.09.2008**
(21) Application number: 07103797.2
(22) Date of filing: 08.03.2007
(51) Int. Cl.: H01J 37/32, C23C 16/44

(54) **Suction device for plasma coating chamber**

(71) Applicant: Applied Materials, Inc., Santa Clara, CA 95054 (US)
(72) Inventor: Wieder, Stephan, 60385, Frankfurt (DE); Repmann, Tobias, 63755, Alzenau (DE); Bibas, Matthias, 01109, Dresden (DE); Stephan, Ulf, 01309, Dresden (DE); Steinke, Olaff, 01454, Radeberg (DE)
(74) Representative: Lang, Christian

(57) **Abstract**

The present invention concerns a device (8) for supporting a plasma-enhanced coating process, said device arrangeable in the vicinity of the plasma and/or the substrate (4) to be coated and/or an electrode (2,3) provided for plasma generation, wherein a frame is provided, which at least partially surrounds or limits a side or a plane of the plasma area or a plane, in which the substrate or a carrying element carrying the substrate can be arranged, or of one of the electrodes or parts thereof, and which comprises a cavity or a suction channel (13) with one or several suction openings (10) through which a gaseous medium can be suctioned off.

## Description

### BACKGROUND OF THE INVENTION

### FIELD OF THE INVENTION

The present invention refers to a device for supporting a plasma-enhanced coating process and to a corresponding plasma or coating chamber.

### PRIOR ART

Plasma-enhanced coating processes in the form of PECVD (Plasma Enhanced Chemical Vapour Deposition) methods or reactive cathode ray sputtering (reactive sputtering) are widely used in industry for coating purposes. For example, PECVD methods for the deposition of thin films of silicon nitride, silicon or of silicon oxides are used for the production of thin film transistors, microelectronic components or solar cells. In the PECVD method, gaseous coating materials are deposited from the gaseous phase onto the substrate to be coated, with the layer-forming pre-products in the gaseous phase reacting to form what is ultimately the coating material. This can be enhanced by the provision of a plasma.

In the methods specified above, it is necessary to introduce corresponding gaseous coating materials into a coating chamber or a plasma chamber where the plasma is ignited, and then to remove the surplus process gas from the chamber.

This is usually realized by a centrally provided exhaust escape opening in the coating chamber. To this central exhaust gas opening is attached, for example, a pumping line such that surplus process gas can be suctioned off by means of a corresponding pump.

For homogeneous layer formation, uniform layer deposition parameters are necessary across the entire surface of the substrate to be coated. For this reason, a central suction point in the coating chamber wall may be problematic, since central suction of surplus process gas may give rise to unfavourable gas flow conditions in the coating chamber.

To solve this problem, German patent DE 197 27 857 C1 proposes a plasma reactor that has an electrode with a gas distribution chamber and a gas suction chamber. However, such an electrode, which provides the gas feed and gas removal simultaneously, is very complex in design and problematic as regards the effectiveness of deposition.

The so-called plasma box (brand name of the company Unaxis) is another possibility that seeks to uniformly regulate the gas flow. The vacuum or plasma chamber in this solution features an additional box inside the vacuum or plasma chamber, said box completely surrounding the coating and plasma area, such that two-stage evacuation of the vacuum chamber and the plasma box is possible. Thus, for example, during coating, a lower pressure can be set in the surrounding vacuum chamber than in the plasma box, such that contaminants cannot get into the plasma box. Additionally, by virtue of an arrangement of corresponding peripheral openings to the surrounding vacuum chamber, the plasma box facilitates uniform gas removal from the plasma box. A description of the plasma box is contained in the publications of Jérôme Perrin, Jaques Schmitt, Christoph Hollenstein, Alan Howling and Laurent Sansonnens, The Physics of Plasma-Enhanced Chemical Vapour Deposition for Large-Area Coating: Industrial Application to Flat Panel Displays and Solar Cells, Plasma Phys. Control. Fusion 42 (2000) B353 to B363 and Hollenstein, Howling, Courteille, Dorier, Sansonnens, Magni and Müller, Dust Particle Diagnostics in RF Plasma Deposition of Silicon and Silicon Oxide Films, Mat. Res. Soc. Symp. Proc. Vol. 507 (1998) Materials Research Society.

The disadvantage of this concept is likewise the very high outlay on the plasma box.

### DISCLOSURE OF THE INVENTION

### OBJECT OF THE INVENTION

It is therefore the object of the present invention to make available a device for a plasma or a coating chamber as well as a corresponding plasma or coating chamber with which plasma-enhanced coating processes can be improved to the extent that uniform and homogeneous coating of even large-area substrates are obtained. Additionally, the corresponding device and plasma or coating chamber are to have simple designs, be easy to operate, and be versatile in use.

### TECHNICAL SOLUTION

This object is achieved by means of a device having the features of claim 1 and a coating chamber having the features of claim 3. Advantageous embodiments are the subject matter of dependent claims.

The invention starts out from the realization that, instead of an elaborate plasma box, a sufficient improvement in the gas flow in a vacuum coating chamber or plasma chamber is possible by means of a so-called suction frame (hereafter called suction device), which has a frame and/or a suction channel with openings for suctioning surplus process gases. Frame here means a plate-, grid- or box-like structure preferably comprising a suction channel. However, the frame may enclose a suction volume (cavity) different from a channel-like structure like cuboidal or other cavities. Alternatively, a pure channel structure may be realized with the suction channel having sufficient rigidity so that additional structural components may be omitted.

The suction device is designed such that it can be arranged in the vicinity of the plasma or coating area, such that the frame and/or the suction channel encloses or limits at least part of the coating area, such that suction of surplus process gas can take place directly in the vicinity of the plasma and/or coating area.

By plasma area here is meant the area in which the plasma in the plasma or coating chamber is present during operation. By coating area is meant the area in which appreciable deposition of the coating materials takes place, thus essentially the area in which the substrate is arranged during coating. Plasma area and coating area can thus be at least partly identical.

Especially, the suction device can be regarded as an at least partially lateral or annular delimitation of the plasma or coating area. The suction device can also be realized as an at least partly provided border in the plane in which the substrate is arranged during the coating or in which a carrying element (carrier) carrying the substrate is provided. Accordingly, the suction device can at least partly also enclose electrodes or parts thereof.

It is advantageous that the suction device, which has one or more suction openings, is in the vicinity of the plasma and/or coating area.

The suction device can be realized as a separate device that can be interchangeably provided in any plasma or coating chamber or as a permanently integrated component in a coating chamber. Accordingly, the present invention pertains on one hand to the suction device (suction frame) itself and on the other to a correspondingly equipped plasma or coating chamber.

The suction channel of the suction device can be formed as closed ring in the form of a circumferential infinite loop, which facilitates uniform suction by means of several suction points, which are distributed over a larger area. Similarly, the suction openings of the frame may be arranged in a ring-like configuration.

The basic shape of the frame and/or suction channel may be rectangular, square, generally polygonal, such as hexagonal or octagonal, round or oval or a different loop shape. Thus, the frame and/or the suction channel can be matched to different requirements.

The frame and/or the suction channel can have an essentially flat structure, such that the device has only a very small thickness expansion relative to the longitudinal and width directions, that is, the suction device with frame and/or suction channel is essentially formed in one plane. This facilitates a very simple structure for the suction device.

The structure can be simplified also by the fact that the suction channel is provided in the frame and especially the suction device is formed from hollow profiles that form the suction channel at the same time, e.g. square or cylindrical pipes.

The suction openings, by means of which the surplus process gas gets into the frame and/or suction channel, can be provided on one or more sides of the frame and/or suction channel, especially at two opposing sides or all sides of the suction device.

The suction openings of the frame and/or suction channel can be oriented both perpendicularly to the plane, which is spanned by the suction device, and parallel to this plane, with the suction openings capable of being directed either into the device centre or outwardly. In the same way, the suction openings can, in the case of orientation perpendicular to the device level, be arranged toward the plasma and/or an opposing electrode arrangement or in the opposite direction.

In an advantageous embodiment, the suction openings can be covered by, especially, exchangeable faceplates with faceplate openings, such that the shape and number of faceplate openings in the faceplates determines the gas flow. Through the use of faceplates, it is firstly possible, to provide large openings in the suction channels, which would otherwise only lead to coarse gas flow. Secondly, in the case of exchangeable faceplates, the form, shape and number of faceplate openings can be simply adjusted to the different requirements of different coating processes. The suction openings and/or faceplate openings can be realized by means of holes, especially of circular shape, slits or other designs.

In order that excessive deposition of coating materials may be prevented from occurring on the suction device and/or that contaminations due to thermophoresis are avoided in the area of the device, heating means can be provided on the suction device for the purpose of heating the corresponding components of the suction device and avoiding corresponding cold spots on the suction device.

The inventive suction device can be used especially with a PECVD coating chamber, with it being advantageous to provide the suction device opposite or circumferential an electrode, especially a shower-head electrode. This allows particularly favourable gas flow to be obtained in the plasma and/or coating area.

According to a further aspect, for which protection is also claimed independently, a stop element is provided, by means of which at least one of the electrodes and/or the substrate and/or the carrying element (carrier), on which the substrate is arranged, can be aligned planar. Appropriately strong pressing of the electrode and/or the carrier frequently used as electrode for the substrate and/or the substrate against the stop element can offset any curvature or twisting of these elements, which might lead to inhomogeneous coating. Since homogeneous coating especially depends on homogeneous formation of the electromagnetic field between the electrodes, which is used for plasma production, plane-parallel alignment of the electrodes is especially important for homogeneous coating. This can be achieved very simply by the use of a stop element with which is aligned, for example, the electrode on which the substrate is located for movement into, through and out of the coating chamber (carrier). Especially, the stop element can be integrated into the frame and/or suction channel of the suction device or find application in combination with the device. Since the suction device already has very high torsional rigidity by virtue of being formed from hollow profiles for example, a corresponding stop element can be realized in a very simple way.

In a separate embodiment of the suction device and of the stop element, the elements can be advantageously arranged adjacent to each other.

The stop element has stop surfaces, which are formed such that, when the substrate, carrier and/or electrode is pressing against the stop surfaces, the corresponding elements such as substrate, carrier and/or electrode have a precisely planar surface and especially a plane-parallel alignment with a counter-electrode. The stop surfaces can be arranged, for example, as peripheral or cross-like or lattice-like bars on the suction device.

The stop element can be of an adjustable, especially movable or slidable, design for adjusting the electrode gap.

In order that the electrode gap in an integrated arrangement of the stop element on the suction device may also be changed, the suction device is also adjustably arranged, especially movably, preferably toward an opposite or facing electrode.

### BRIEF DESCRIPTION OF THE FIGURES

Further advantages, characteristics and features of the present invention are apparent from the following detailed description of preferred embodiments using the enclosed drawings. The drawings show in purely schematic form:
- Fig. 1: a schematic view of a PECVD coating chamber;
- Fig. 2: a lateral view of a suction device of the invention such as is used in the PECVD-coating chamber of Fig. 1;
- Fig. 3: a plan view of a suction device from Fig. 2;
- Fig. 4: a side view of the suction device of Fig. 2, rotated through 90°; and in
- Fig. 5: a detailed view of the upper edge of a modified embodiment of the suction device of Fig. 2.

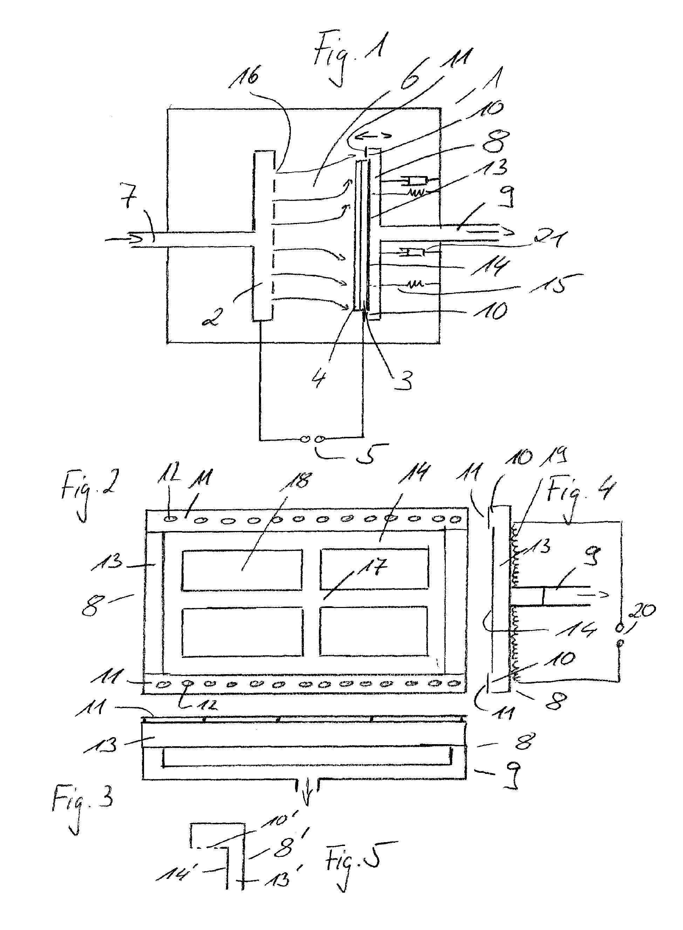

Fig. 1 is a purely schematic representation a PECVD (Plasma Enhanced Chemical Vapour Deposition) coating chamber 1 for performing plasma-enhanced chemical vapour phase deposition.

For this, two electrodes 2 and 3 are provided, with the substrate 4 being arranged on one of the electrodes 3. The electrode 3 is thus formed as the carrying element for the substrate 4, with the carrying element, also called carrier, capable of carrying the substrate 4 throughout transport through the coating installation. Accordingly, the electrode 3 in the form of carrying element or carrier is only used as electrode during coating. Accordingly, this component is designated in the following both as electrode and as carrying element and/or carrier. The electrodes 2, 3 can be arranged either vertically or horizontally.

A plasma 6 between the electrodes 2 and 3 can be ignited by means of a voltage supply 5, said plasma both exciting the chemical reaction of the coating materials introduced in gaseous form and generally enhancing coating. The gaseous coating materials are then deposited after, during or in advance of the corresponding chemical reaction on the substrate 4 to form the coating there.

In order that the gaseous coating materials may be introduced uniformly into the plasma area 6, the embodiment shown uses a so-called shower-head electrode 2, which is hollow, in order that gaseous coating materials may be transported via a feed 7 through the cavity of the electrode 2 to the electrode openings 16 provided on the electrode surface, where the gaseous coating materials can flow uniformly into the plasma area 6.

In order now that uniform and homogeneous flow of the gaseous coating materials, as represented in Fig. 1 by the arrows between the electrodes 2 and 3, may be obtained, a suction device 8 provided behind the electrode or the carrier 3 projects laterally over the carrier 3 and the substrate 4 arranged on it in order that it may suction off surplus process gas there.

For this purpose, the suction device 8 has a suction channel 13, which, due to formation of the suction device 8 with hollow profiles, especially in the form of square or cylindrical pipes, is integrally formed in the suction device 8.

As may especially be seen in Fig. 2, the suction device 8 with the integral suction channel 13 is formed as a closed rectangular or peripheral ring, with, in the embodiment of Figs. 1 to 4, openings 10 or 12 provided at the upper and lower longitudinal side of the suction device 8 through which the surplus process gas can be suctioned off. The openings 10 provided directly in the suction channel 13 are covered in the embodiment shown in Figs. 1 to 4 by a faceplate 11, with the faceplate 11 having a plurality of faceplate openings 12 through which uniform in-flow of the surplus process gas into the openings 10 is made possible.

The provision of faceplates with a plurality of smaller faceplate openings facing the suction channel 13 has the advantage that the faceplates 11 can be arranged exchangeably, such that by replacing the faceplates with other faceplates 11 having different faceplate openings as regards the number and shape of the faceplate openings 12, adjustment to altered deposition conditions and flow conditions can be easily realized. Accordingly, the number and shape of faceplate openings 12, but also the openings 10 provided directly in the suction channel 13, can be different.

In the embodiment shown in Figs. 1 to 4, the faceplates or suction openings 12, 10 are only provided at the opposite longitudinal sides of the suction device 8. Alternatively corresponding faceplates and/or suction openings 10 can also be provided on all sides of the suction device 8 or only on individual sides of the suction device 8.

Fig. 5 shows an alternative arrangement of the suction openings, wherein, in the alternative embodiment of the suction device 8', the openings 10' are provided directly in the suction channel 13', without provision of additional faceplates.

Further, the embodiment of the suction device 8' of Fig. 5 differs from the suction device 8 in Figs. 1 to 4 in that the openings are not aligned toward the opposite electrode 2, that is, perpendicularly to the plane spanned by the suction device, but rather on the inside of the device parallel to the plane spanned by the suction device 8'. Accordingly, in the embodiment of the suction device 8', the flow is adjusted increasingly parallel to the electrode 3 provided on the stop surface 14' or the substrate 4 arranged on it.

The process gas sucked in by the suction openings 10 is transported across the suction channel 13 to the gas outlet 9, which can, for example, be connected to a pump (not shown). Especially, in a modular formation of the coating chamber 1, in which the suction device 8 is detachably accommodated in the coating chamber 1, a corresponding line connection can be permanently provided to a suction nozzle in the coating chamber wall.

Apart from the function of creating uniform and homogeneous flow of the process gas or the gaseous coating materials relative to the substrate 4, the suction device 8, as illustrated in the embodiments of Figs. 1 to 5, has an additional function, which consists in serving as a stop for the carrying element or the carrier 3 and thus the electrode 3 as well as the substrate 4. Apart from the uniform and homogeneous distribution of the process gas and/or the gaseous coating materials relative to the substrate surface to be coated, it is also important for uniform coating that the electromagnetic conditions concerning the substrate surface and/or the electrodes be likewise homogeneous and uniform. Accordingly, it is necessary for the electrode surfaces of the electrodes 2 and 3 to be as plane-parallel as possible. While this is easily achievable for the stationary electrode 2, it is not a trivial matter for the movable electrode 3, which functions additionally as carrying element and/or carrier.

By means of the inventive suction device or a coating or plasma chamber correspondingly equipped with it, it is a simple matter to align the electrode 3 or the carrier 3 with the substrate 4 opposite the electrode 2 such that it is plane parallel. This is achieved by pressing the carrying element or the carrier 3 with the substrate 4 against the suction device 8, which has a stop surface 14 provided for that purpose.

As may be seen in Fig. 2, the stop surface 14 may be realized in the form of circumferential as well as cross-like or lattice-like bars 17 at the suction channel 13, which make it possible to accommodate corresponding contact pressures and through which a planar alignment of the substrate 4 or the electrode 3 can be obtained.

In order that appropriate contact forces against the stop surface 14 may be obtained, corresponding drive or retaining means 15 can be provided, which, for example, can engage with the back of the carrier or the electrode 3 through recesses 18 in the suction device 8, to draw them against the stop surface 14 of the suction device 8.

The suction device 8 is adjustably or movably mounted in the coating chamber 1 as indicated by the double-headed arrow, such that the electrode gap between the electrodes 2 and 3 is adjustable. For this, corresponding drive components 21 are provided, e.g. in the form of pneumatic or hydraulic cylinders, electric drives or the like. Simple mechanical spacers (not shown), which enable default positions to be adjusted, are also conceivable. In this way, the gaps between the electrodes 2 and 3 can be varied for different coating purposes, without any change in the position of the suction openings 10 of the suction device 8 in relation to the electrode 3 or the substrate 4.

In an alternative embodiment not shown here, the use of separate components, which, however, are preferably provided in combination with one another, can enable the functions of the suction device 8 to also be separated with regard to suction of the surplus process gases on one hand and the provision of a stop surface for the electrode and/or the carrier 3 as well as the substrate 4 on the other.

Figs. 2 to 4 show in greater detail the suction device 8, such as is used in the coating chamber 1 of Fig. 1, more precisely on one hand in a side view of the principal surface of the suction device 8 (Fig. 2), a plan view of the longitudinal side from above (in Fig. 3) and in a side view of the end-face rotated through 90° (Fig. 4).

The details of Fig. 2, again, show that the suction device 8 has a rectangular suction channel 13, which, with its basic structure of square pipes constitutes both the suction channel 13 and the basic structure of the frame. On the upper and lower longitudinal sides are provided faceplates 11, which cover the suction openings 10 arranged there and, by means of a plurality of faceplate openings 12, facilitate a defined flow in the plasma area 6 or in the coating area directly around the substrate 4.

At the suction channel 13 inside the suction device 8 are provided bars 17 that form a stop surface 14 for the electrode 3 or carrier 3 and thus for the substrate 4. Thus, planar alignment of the carrier 3 or substrate 4 and corresponding plane parallelism to the counter-electrode 2 are achieved.

Fig. 3 shows in detail the connection 9 to the suction nozzle of the coating chamber 1, wherein the embodiment shown has two exits on the suction channel 13, especially the vertical areas, as may also be seen in Fig. 4, said exits capable of being guided via a common line to the suction nozzle of the coating chamber.

Fig. 4, again, shows a side view of the suction openings 10 on the upper and lower longitudinal sides of the suction device 8 as well as the faceplates 11 with the corresponding faceplate openings provided there. Additionally, the connection 9 to the suction nozzle of the coating chamber 1 may also be seen.

Additionally, Fig. 4 shows a heating element 19, for example, in the form of a resistance heater, which is connected to a current or voltage supply 20. The heating element 19 can be used for heating the suction device 8 to avoid formation of deposits on the suction device 8.

Although the present invention has been described in detail with regard to preferred embodiments using the enclosed drawings, it is clear to a person skilled in the art that modifications and amendments, especially in a different type of combination of the described individual characteristics or in the exclusion of certain characteristics, are possible, without surrendering the scope of protection of the enclosed claims.

## Claims

1. Device for supporting a plasma-enhanced coating process being designed such that it can be arranged in the vicinity of a plasma and/or a substrate to be coated and/or an electrode for plasma generation in a plasma or coating chamber,
**characterized by the fact that**
a frame is provided, which at least partially surrounds or limits a side or a plane of the plasma area or a plane, in which the substrate or a carrying element carrying the substrate can be arranged, or of one of the electrodes or parts thereof when the device is arranged in the plasma or coating chamber, and which comprises a cavity or a suction channel (13) with one or several suction openings (10) through which a gaseous medium can be suctioned off.

2. Device in accordance with claim 1,
**characterized by the fact that**
means are provided for especially detachable arrangement in a coating or plasma chamber and/or connecting means for especially detachable connection of the cavity or suction channel to the suction exit of a coating or plasma chamber.

3. Coating chamber for plasma-enhanced coating of a substrate with a plasma area in which the plasma is generated and a coating area in which the substrate is coated,
**characterized by the fact that**
in or at the plasma and/or coating area is provided at least one frame surrounding or limiting at least part of the plasma and/or coating area, said frame comprising a cavity or a suction channel (13) which has one or more suction openings (10) and through which a gaseous medium can be suctioned off.

4. Device in accordance with claims 1, 2 or coating chamber in accordance with claim 3,
**characterized by the fact that**
the frame and/or the suction channel (13) is provided as a closed ring.

5. Device in accordance with claims 1, 2 or 4 or coating chamber in accordance with claims 3 or 4,
**characterized by the fact that**
the frame and/or the suction channel (13) has a rectangular, polygonal, round, oval or loop-shaped basic shape.

6. Device in accordance with any of claims 1, 2 or 4 to 5 or coating chamber in accordance with any of claims 3 to 5,
**characterized by the fact that**
the frame and/or the suction channel (13) has a large-area structure such that the frame and/or the suction channel is essentially arranged in a plane, with especially the longitudinal and width extensions being very much greater than the thickness.

7. Device in accordance with any of claims 1, 2 or 4 to 6 or coating chamber in accordance with any of claims 3 to 6,
**characterized by the fact that**
the suction channel (13) is provided in the frame.

8. Device in accordance with any of claims 1, 2 or 4 to 7 or coating chamber in accordance with any of claims 3 to 7,
**characterized by the fact that**
the suction channel (13) or cavity has suction openings (10) on one or more sides of the frame, especially opposing sides, preferably two opposing sides of the frame, with especially the suction openings being uniformly distributed along the length, preferably at equal distances apart.

9. Device in accordance with any of claims 1, 2 or 4 to 8 or coating chamber in accordance with any of claims 3 to 8,
**characterized by the fact that**
the suction openings with their suction direction are aligned perpendicularly to the plane spanned by the device and/or toward the centre of the device in the plane spanned by the device.

10. Device in accordance with any of claims 1, 2 or 4 to 9 or coating chamber in accordance with any of claims 3 to 9,
**characterized by the fact that**
the suction openings (10) are covered especially by exchangeable faceplates (11) with faceplate openings (12).

11. Device in accordance with any of claims 1, 2 or 4 to 10 or coating chamber in accordance with any of claims 3 to 10,
**characterized by the fact that**
the suction openings or faceplate openings (12) are formed by holes and/or slits, especially a plurality of uniformly distributed holes and/or slits.

12. Device in accordance with any of claims 1, 2 or 4 to 11 or coating chamber in accordance with any of claims 3 to 11,
**characterized by the fact that**
heating means (19) are provided, by means of which the components of the device, especially the frame and/or suction channel, can be heated.

13. Device in accordance with any of claims 1, 2 or 4 to 12 or coating chamber in accordance with any of claims 3 to 12,
**characterized by the fact that**
a stop surface (14) for an electrode, for the substrate and/or a carrying element for the substrate is provided for.

14. Coating chamber in accordance with any of claims 3 to 13,
**characterized by the fact that**
the device is provided opposite or circumferential an electrode (12), especially an electrode with gas inlets.

15. Coating chamber in accordance with any of claims 3 to 14,
**characterized by the fact that**
the device is provided adjacent to an especially adjustable stop element for the substrate, an electrode, and/or a carrying element for the substrate.

16. Coating chamber in accordance with any of claims 3 to 15,
**characterized by the fact that**
the coating chamber (1) is set up for plasma-enhanced chemical vapour deposition.

17. Coating chamber in accordance with any of claims 3 to 16,
**characterized by the fact that**
the substrate may be arranged relative to the device during coating, such that the gas flow proceeds toward the principal surface of the substrate and along the side of it.

18. Coating chamber in accordance with any of claims 3 to 17,
**characterized by the fact that**
the device is adjustable, especially slidable, preferably toward an opposing electrode.
